# EUROPÄISCHE PATENTSCHRIFT

(11) **EP 2 171 334 B1**
(45) Veröffentlichungstag und Bekanntmachung des Hinweises auf die Patenterteilung: **06.04.2011**
(21) Anmeldenummer: 08772590.9
(22) Anmeldetag: 21.07.2008
(51) Int. Cl.: F16K 51/02, F16K 3/18

(54) **VERFAHREN ZUR STEUERUNG ODER REGELUNG EINES VAKUUMVENTILS**
METHOD FOR CONTROLLING OR REGULATING A VACUUM VALVE
PROCÉDÉ DE COMMANDE OU DE RÉGULATION D'UNE SOUPAPE À VIDE

(30) Priorität: 24.07.2007 DE 102007034927
(43) Veröffentlichungstag der Anmeldung: 07.04.2010
(73) Patentinhaber: VAT Holding AG, 9469 Haag (CH)
(72) Erfinder: FISCHER, Richard, A-6830 Rankwell (AT)
(74) Vertreter: Hofmann, Ralf U.
(86) Internationale Anmeldenummer: PCT/AT2008/000264
(87) Internationale Veröffentlichungsnummer: WO 2009/012510

(56) Entgegenhaltungen:
- DE-C1- 4 023 845
- US-A- 6 073 655
- US-A1- 2002 088 959

## Beschreibung

Die Erfindung betrifft ein Verfahren zur Steuerung oder Regelung eines Vakuumventils, welches umfasst:
- einen Ventilkörper mit einer Ventilöffnung,
- ein Verschlussglied, das zum Schließen des Vakuumventils zwischen einer Offenstellung und einer Schließstellung verstellbar ist und in der Schließstellung die Ventilöffnung verschließt, wobei mindestens eine elastische Dichtung mit einer Presskraft an eine Dichtfläche angedrückt ist,
- einen Aktuator zum Verstellen des Verschlussglieds und
- eine Steuereinrichtung, mittels der der Aktuator angesteuert wird und von der die in der Schließstellung des Verschlussglieds auf die elastische Dichtung wirkende Presskraft eingestellt wird.

Bekannt sind Steuereinrichtungen für Vakuumventile, welche einen Aktuator zum Öffnen und Schließen des Verschlussgliedes ansteuern, wobei zum Aktivieren des Aktuators diesem ein entsprechendes Betriebsmittel, meist Druckluft, zugeführt wird. Es sind hierbei selbstöffnende und selbstschließende Ventile bekannt, bei denen bei Wegfall des Betriebsmittels durch Federelemente die Offenstellung bzw. Schließstellung des Verschlussgliedes aufrecht erhalten wird. Neben pneumatisch angetriebenen Vakuumventilen sind auch elektrisch angetriebene Vakuumventile bekannt. Es ist auch bekannt, der Steuereinrichtung verschiedene Eingangssignale über den Ventilzustand zuzuführen, um Sicherheitsfunktionen zu realisieren, d. h. das Öffnen oder Schließen des Vakuumventils bei bestimmten Zuständen des Vakuumsystems zu verhindern oder zu veranlassen.

Aus der US 7,036,794 B2 ist ein Verfahren zur Steuerung eines Vakuumventils bekannt, bei dem die auf die elastische Dichtung wirkende Presskraft von der Steuereinrichtung in Abhängigkeit von einem ermittelten Wert für den Differenzdruck zwischen den beiden Vakuumkammern, zwischen denen das Vakuumventil angeordnet ist, eingestellt wird. Es kann dadurch der Verschleiß der elastischen Dichtung verringert werden.

Dokument DE 4023845 offenbart auch ein Verfahren zur Steuerung eines Vakuumventils.

Aufgabe der Erfindung ist es, erweiterte Möglichkeiten der Steuerung bzw. Regelung eines Vakuumventils der eingangs genannten Art bereitzustellen. Erfindungsgemäß gelingt dies durch ein Verfahren mit den Merkmalen des Anspruchs 1.

Die Erfindung geht hierbei von dem Grundgedanken aus, dass Vorteile erreicht werden können, wenn die auf die elastische Dichtung wirkende Presskraft in Abhängigkeit von mindestens einer dem Benutzer bereitgestellten Eingabemöglichkeit erfolgt. Beispielsweise kann ein durch eine Benutzereingabe ausgewählter Parameter eine von mindestens zwei möglichen Konfigurationen des Vakuumventils widerspiegeln. So kann diese auswählbare Konfiguration beispielsweise die Ausbildung der elastischen Dichtung hinsichtlich des Materials, aus dem sie besteht, oder ihrer Geometrie sein. Es kann dadurch bei unterschiedlichen Ausbildungen von eingesetzten Dichtungen die für eine geforderte Gasdichtheit bei gleichzeitig zur Schonung der Dichtung möglichst geringer Verpressung der Dichtung optimierte Presskraft, die auf die Dichtung wirkt, eingestellt werden.

Anstelle einer Eingabemöglichkeit für eine Konfiguration des Vakuumventils oder zusätzlich hierzu kann weiters vorgesehen sein, eine Eingabemöglichkeit für den Benutzer vorzusehen, durch welche dieser einen von mindestens zwei möglichen Betriebsmodi auswählen kann, wobei die Einstellung der auf die elastische Dichtung wirkenden Presskraft in Abhängigkeit vom ausgewählten Betriebsmodus erfolgt. So können beispielsweise zumindest ein "Prozessmodus" und ein "Servicemodus" vorgesehen sein, wobei im Servicemodus eine höhere Presskraft auf die elastische Dichtung ausgeübt wird als im Prozessmodus. Im Servicemodus kann dadurch eine sichere Abdichtung mit einer geringen Leckrate erreicht werden, während im Prozessmodus die Dichtung geschont wird.

Anstelle einer manuellen Eingabe mindestens eines Parameters, der eine von mindestens zwei möglichen Konfigurationen des Vakuumventils oder einen von mindestens zwei möglichen Betriebsmodi des Vakuumventils darstellt, ist es auch denkbar und möglich, dass ein solcher Parameter von der Steuereinrichtung automatisch erfasst wird. Die Einstellung der auf die elastische Dichtung wirkenden Presskraft in Abhängigkeit von mindestens einem solchen Parameter- unabhängig davon, ob dieser manuell eingegeben oder automatisch erfasst wird - stellt somit einen als unabhängig zu betrachtenden Aspekt der Erfindung dar.

Wenn im Rahmen dieser Schrift von einer "Steuereinrichtung" die Rede ist, so sind durch diesen Begriff alle, insbesondere elektronischen, Einrichtungen umfasst, von denen Steuerungsvorgänge im Sinne von offenen Steuerungen oder von Regelungen umfassend mindestens einen Regelkreis oder von Kombinationen hiervon durchgeführt werden können.

In einer Ausführungsform der Erfindung kann der Aktuator eine Kraftsteuerung oder - regelung erlauben, d. h. die von ihm ausgeübte Schließkraft ist von der Steuerungseinheit einstellbar, wobei die im geschlossenen Zustand des Vakuumventils auf die Dichtung wirkende Presskraft durch die Einstellung der Schließkraft des Aktuators gesteuert bzw. geregelt wird.

In Abhängigkeit vom Typ des eingesetzten Vakuumventils kann die auf die elastische Dichtung wirkende Presskraft dabei entweder allein von der vom Aktuator ausgeübten Schließkraft herrühren oder die Presskraft ergibt sich aus der Überlagerung der vom Aktuator ausgeübten Schließkraft mit einer vom Differenzdruck zwischen den beiden Vakuumkammern hervorgerufenen Kraft.

In einer weiteren Ausführungsform der Erfindung kann der die Dichtung an die Dichtfläche anlegende Aktuator eine Lage- oder Positionssteuerung oder -regelung erlauben, d. h. die Schließposition des Verschlussgliedes ist von der Steuerungseinheit einstellbar, wobei die im geschlossenen Zustand des Vakuumventils auf die Dichtung wirkende Presskraft durch Einstellung der Schließposition des Verschlussgliedes gesteuert bzw. geregelt wird.

Das erfindungsgemäße Verfahren ist im Zusammenhang mit sehr unterschiedlichen Typen von Ventilen einsetzbar. Beispielsweise kann das Ventil in einer Weise ausgebildet sein, bei welchem die gesamte Schließbewegung zwischen der Offenstellung und der Schließstellung des Verschlussgliedes für alle Teile des Verschlussgliedes gradlinig erfolgt. Solche Vakuumventile sind beispielsweise aus der US 4,809,950 A, US 6,685,163 B2 oder US 4,921,213 A bekannt.

Das Verfahren ist beispielsweise auch bei Ventilen einsetzbar, die nach Art von Schieberventilen ausgebildet sind, wie diese beispielsweise aus der US 4,052,036 A oder US 4,470,576 A bekannt sind.

Auch eine Ausbildung des Vakuumventils nach Art eines Butterfly-Ventils ist beispielsweise denkbar und möglich. Solche Butterfly-Ventile sind beispielsweise aus der US 4,634,094 A oder US 6,494,434 B1 bekannt.

Weiters ist auch eine Ausbildung des Vakuumventils beispielsweise als L-Ventil denkbar und möglich. Ein solches L-Ventil ist beispielsweise aus der US 6,431,518 B1 bekannt. Die einzelnen Bewegungskomponenten der L-Bewegung können hierbei vom gleichen oder von unterschiedlichen Aktuatoren hervorgerufen werden.

Weiters ist beispielsweise auch eine Ausbildung des Vakuumventils möglich, bei der das Verschlussglied V-förmig ausgebildet ist und beidseitig Dichtungen aufweist, die an entsprechenden gegengleichen Dichtflächen anliegen, wie dies aus der US 6,367,770 B1 hervorgeht.

Weitere Vorteile und Einzelheiten der Erfindung werden im Folgenden anhand der beiliegenden Zeichnung erläutert. In dieser zeigen:
- Fig. 1: eine schematische Darstellung eines zwischen zwei Vakuumkammern angeordneten Vakuumventils, das Vakuumventil schematisch im Schnitt entlang der Achse der Ventilöffnung dargestellt, in der Schließstellung des Verschlussgliedes;
- Fig. 2: einen schematischen Schnitt des Vakuumventils von Fig. 1 in Richtung quer zur Ach- se der Ventilöffnung, in der Offenstellung des Verschlussgliedes;
- Fig. 3: ein Diagramm der Geschwindigkeit des Verschlussgliedes und der Stromstärke des Aktuators in Abhängigkeit vom Weg des Verschlussgliedes;
- Fig. 4: eine schematische Darstellung einer weiteren Ausführungsform eines zwischen zwei Vakuumkammern angeordneten, in erfindungsgemäßer Weise steuer- bzw. regelba- ren Vakuumventils;
- Fig. 5: eine schematische Schnittdarstellung einer weiteren Ausführungsform eines in er- findungsgemäßer Weise steuer- bzw. regelbaren Vakuumventils.

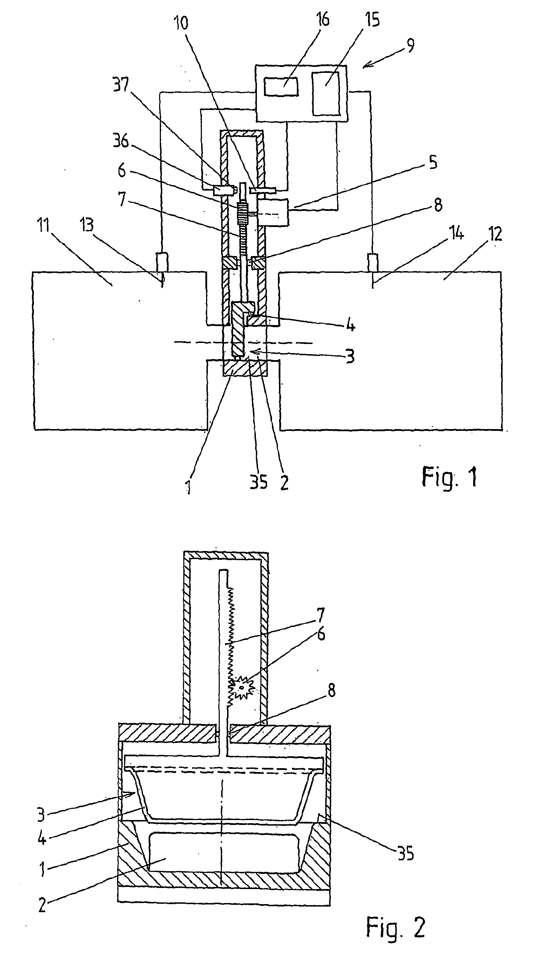

Ein Beispiel für ein Vakuumventil, bei dem das erfindungsgemäße Verfahren ausführbar ist, ist schematisch in den Fig. 1 und 2 dargestellt. Das Vakuumventil umfasst einen Ventilkörper 1 mit einer in Form eines Durchgangskanals ausgebildeten Ventilöffnung 2 und ein Verschlussglied 3. Das Verschlussglied 3 gibt in einer Offenstellung (Fig. 2) die Ventilöffnung 2 frei und verschließt in einer Schließstellung die Ventilöffnung 2 (Fig. 1). In der Schließstellung des Verschlussglieds 3 ist eine elastische Dichtung 4 an eine Dichtfläche 35 angedrückt. Die Dichtung 4 ist hier am Verschlussglied 3 und die Dichtfläche 35 am Ventilkörper 1 angeordnet. Eine umgekehrte Anordnung ist ebenfalls möglich.

Die Dichtung 4 weist in dieser Ausführungsform des Vakuumventils in zwei parallelen, in

Richtung der Längsachse der Ventilöffnung 2 voneinander beabstandeten Ebenen liegende Abschnitte auf, die über Verbindungsabschnitte miteinander verbunden sind. Eine derartige Ausbildung eines Verschlussgliedes 3 und der Dichtfläche 35 des Ventilkörpers 1 ist bekannt und beispielsweise in der US 4,809,950 B beschrieben.

Zum Verfahren des Verschlussgliedes 3 aus seiner in Fig. 2 dargestellten Offenstellung in seine in Fig. 1 dargestellte Schließstellung dient ein Aktuator 5, der in diesem Ausführungsbeispiel in Form eines Elektromotors, beispielsweise eines AC-Servomotors, DC-Servomotors oder eines Schrittmotors ausgebildet ist. Die Verstellung des Verschlussgliedes 3 mittels des Aktuators 5 erfolgt über zwischengeschaltete Getriebeglieder, im gezeigten Ausführungsbeispiel sind schematisch ein Ritzel 6 und eine Zahnstange 7 dargestellt. An einem Fortsatz der Zahnstange 7 ist das Verschlussglied 3 befestigt. Dieser eine Ventilstange bildender Fortsatz der Zahnstange 7 ist hierbei abgedichtet (Dichtung 8) und verschiebbar in den Vakuumbereich des Vakuumventils hineingeführt.

Der Aktuator 5 wird von einer Steuereinrichtung 9 angesteuert, wobei die Bewegung des Aktuators 5 von der Steuereinrichtung 9 kontrolliert wird. Die Steuereinrichtung 9 weist eine Eingabevorrichtung 15, beispielsweise Tastatur, zum Eingeben von Daten, beispielsweise Parameter bzw. Eingangsgrößen für die Steuerung oder Regelung auf. Weiters weist die Steuereinrichtung 9 eine Ausgabevorrichtung 16, beispielsweise ein Display oder einen Bildschirm auf. Auch eine akustische Ausgabe kann vorhanden sein.

Es könnten auch mehrere von der Steuereinrichtung 9 angesteuerte Aktuatoren 5 vorhanden sein.

Im gezeigten Ausführungsbeispiel wird die Stellung des Verschlussglieds 3 durch einen Sensor 10 erfasst, beispielsweise durch Erfassung einer an der Zahnstange 7 angeordneten Codierung. Die erfasste Position des Verschlussgliedes 3 wird der Steuereinrichtung 9 zur Ausbildung eines Regelkreises zugeführt. In diesem Ausführungsbeispiel erfolgt also eine Regeiung der Bewegung des Verschlussgliedes 3, wie dies bevorzugt ist.

Es ist weiters eine Bremse bzw. Haltevorrichtung 36 vorhanden, von der das Verschlussglied 3 zumindest in der Schließstellung festgestellt werden kann, vorzugsweise auch in anderen Positionen, beispielsweise in der Offenstellung oder an jeder Stelle seines Schließweges. Die in Fig. 1 nur schematisch dargestellte Haltevorrichtung 36, die von der Steuereinrichtung 9 betätigt wird, kann günstiger Weise selbstschließend ausgebildet sein, d. h. bei Zufuhr eines Betriebsmittels, z. B. Strom oder Druckluft, ist sie geöffnet und ohne Betriebsmittelzufuhr schließt sie. Beispielsweise kann hierzu eine Federeinrichtung vorhanden sein, die ein Reibelement 37 an ein mit dem Verschlussglied 3 verbundenes Teil, z. B. die Zahnstange 7 andrückt.

Es können beispielsweise elektromechanische, elektromagnetische Haltevorrichtungen 36 oder Pneumatik-Haltevorrichtungen 36 eingesetzt werden.

Das Vakuumventil ist zwischen Vakuumkammern 11, 12 angeordnet und über das Vakuumventil wird somit eine Kommunikation zwischen den Vakuumkammern 11, 12 oder ein gasdichter Verschluss zwischen den Vakuumkammern 11, 12 ermöglicht. Beispielsweise kann in einer der Vakuumkammern 11 ein Prozess an mindestens einem zu bearbeitenden Werkstück, beispielsweise einem Waver, durchgeführt werden. Die andere Vakuumkammer 12 kann beispielsweise eine Transferkammer sein.

Vorzugsweise sind weiters in Fig. 1 schematisch dargestellte Drucksensoren 13, 14 vorhanden, von denen der in der jeweiligen Vakuumkammer 11, 12 herrschende Druck erfassbar ist. Die Druckmesswerte werden der Steuereinrichtung 9 zugeführt.

Um in der Schließstellung des Verschlussglieds 3 einen vakuumdichten Verschluss der Ventilöffnung 2 des Vakuumventils zu erreichen, wird vom Aktuator 5 eine Schließkraft auf das Verschlussglied 3 ausgeübt, mit der dieses in der Schließstellung gegen den am Ventilkörper 1 vorgesehenen Ventilsitz gedrückt wird, wobei die elastische Dichtung 8 an die Dichtfläche 35 angedrückt wird. Die auf die Dichtung 4 wirkende Presskraft, mit der sie an die Dichtfläche 35 angedrückt wird, wird in diesem Ausführungsbeispiel der Erfindung im Wesentlichen nur von der vom Aktuator 5 ausgeübten Schließkraft bewirkt (und nicht von einem gegebenenfalls zwischen den Ventilkammern 11, 12 vorliegenden Differenzdruck). Die Presskraft, mit der die Dichtung 4 an die Dichtfläche 35 angedrückt wird, kann auch als "Dichtkraft" bezeichnet werden.

Vom Benutzer können über die Eingabevorrichtung 15 unterschiedliche Eingaben durchgeführt werden. Mindestens eine dieser Eingaben legt einen Parameter der Steuereinrichtung 9 fest, der die von der Steuereinrichtung 9 eingestellte auf die Dichtung 4 wirkende Dichtkraft beeinflusst. Die die Dichtkraft beeinflussenden Benutzereingaben können hierbei folgende Eingaben einzeln oder in beliebiger Kombination umfassen:
Vom Benutzer kann durch eine Eingabe in die Eingabevorrichtung 15 eine Auswahl unter mindestens zwei von der Steuereinrichtung 9 bereitgestellten Betriebsmodi getroffen werden. Einer dieser Betriebsmodi ist hierbei ein Servicemodus zur Durchführung eines Service in einem Vakuumbereich, der in der Schließstellung des Verschlussglieds 3 vom Vakuumventil abgeschlossen wird. Insbesondere wird dieser Vakuumbereich vom Innenraum einer der beiden Vakuumkammern 11, 12 gebildet, zwischen denen das Vakuumventil angeordnet ist. Im Servicemodus wird eine relativ hohe Presskraft auf die elastische Dichtung 4 ausgeübt, um eine sichere Abdichtung mit einer geringen Leckrate der unter Vakuum verbleibenden Vakuumkammer 11, 12 zu erreichen, wenn die andere der Vakuumkammern 11, 12 geflutet wird. Weiters wird von der Steuereinrichtung 9 ein Prozessmodus bereitgestellt. In diesem können Vakuumprozesse unter Einsatz eines Prozessgases in einer der Vakuumkammern 11, 12 (oder in beiden Vakuumkammern 11, 12 mit verschiedenen Prozessgasen) durchgeführt werden, wobei eine Gasverschleppung des eingesetzten Prozessgases in die jeweils andere Kammer zumindest weitgehend vermieden wird. Hierzu kann eine niedrigere auf die Dichtung 4 wirkende Presskraft eingestellt werden.

Der weitaus überwiegende Teil von Schließvorgängen des Vakuumventils wird üblicherweise im Zuge der mit der Anlage, beispielsweise Halbleiterprozessanlage, durchgeführten Prozesse vorgenommen, wobei die Lebensdauer der elastischen Dichtung 4 durch die im Prozessmodus eingestellte niedrigere Presskraft erhöht werden kann, ganz besonders wenn aggressive Prozessgase eingesetzt werden.

Beispielsweise kann die auf die Dichtung 4 einwirkende Presskraft im Servicemodus mehr als 2 N pro mm Dichtungslänge betragen, z. B. 3 N pro mm Dichtungslänge. Im Prozessmodus kann die auf die Dichtung 4 einwirkende Presskraft beispielsweise im Bereich zwischen 0,1-1 N pro mm Dichtungslänge liegen, z. B. bei etwa 0,3 N pro mm Dichtungslänge.

Als weiterer Betriebsmodus kann beispielsweise ein Transportmodus vorhanden sein, in dem ein Transport des Vakuumventils erfolgt. Hierbei kann eine Verriegelung für das Verschlussglied in der Schließstellung aktiviert sein.

Vom Benutzer kann durch eine Eingabe in die Eingabevorrichtung 15 eine vorliegende Konfiguration des Vakuumventils eingegeben werden, wobei mindestens zwei Eingabemöglichkeiten bzw. Auswahlmöglichkeiten für unterschiedliche Konfigurationen vorhanden sind. Die Konfiguration kann beispielsweise die Ausbildung der verwendeten elastischen Dichtung 4 hinsichtlich ihres Materials und/oder hinsichtlich ihrer Geometrie betreffen. So könnte eine Auswahl zwischen elastischen Dichtungen bestehend aus FKM (Flour Elastomer, Viton), FFKM (Perflour Elastomer) oder Silikon ermöglicht werden, wobei die eingestellte Dichtkraft vom jeweiligen Material der Dichtung abhängt. Beispielsweise kann bei einer Dichtung bestehend aus einem FFKM oder Silikon eine geringere Presskraft als bei einer aus FKM bestehenden Dichtung 4 eingestellt werden. Die eingestellte Presskraft könnte auch von der Geometrie der eingesetzten Dichtung abhängig gemacht werden. Die Konfiguration, in Abhängigkeit von der die Presskraft eingestellt wird, könnte statt dessen oder zusätzlich die Ausbildung des eingesetzten Verschlussgliedes 3 betreffen. Es kann hierbei eine Auswahl unter verschiedenen Verschlussgliedern 3 ermöglicht werden, die sich hinsichtlich ihrer Geometrie und/oder hinsichtlich der Geometrie und/oder des Materials der an ihnen (fix) oder austauschbar angeordneten elastischen Dichtung 4.unterscheiden.

Weiters kann eine Benutzereingabe in die Eingabevorrichtung 15 der Steuereinrichtung 9 ermöglicht werden, mit der die Art (d. h. chemische Zusammensetzung) mindestens eines Prozessgases ausgewählt wird, mit der die elastische Dichtung 4 in Berührung kommt, wobei die auf die elastische Dichtung im Schließzustand des Verschlussglieds 3 wirkende Presskraft in Abhängigkeit von der Art des Prozessgases eingestellt wird. Für unterschiedliche Prozessgase könnten dadurch beispielsweise unterschiedliche Leckraten vorgegeben werden. Dadurch kann die Lebensdauer der elastischen Dichtung 4 erhöht werden. Die auf die elastische Dichtung 4 im Schließzustand einwirkende Presskraft kann auch in Abhängigkeit vom Druck des Prozessgases variiert werden.

Weiters kann eine Eingabe eines Parameters über die Eingabevorrichtung 15 der Steuereinrichtung 9 ermöglicht werden, der die Anzahl der beim Schließvorgang des Vakuumventils gebildeten Partikel reflektiert. In Abhängigkeit von diesem Parameter kann (u. a.) die auf die Dichtung 4 ausgeübte Presskraft eingestellt werden, da die Partikelgeneration auch von der Stärke der Verpressung der Dichtung 4 abhängt. Es könnte hier bei Prozessen, die gegenüber generierten Partikeln empfindlich sind, eine höhere Leckrate des Vakuumventils im geschlossenen Zustand in Kauf genommen werden. Auch die Schließgeschwindigkeit, mit der die Dichtung 4 auf die Dichtfläche 35 auftrifft, kann in Abhängigkeit von der erlaubten Partikelgeneration variiert werden.

Anstelle einer Benutzereingabe eines Parameters, in Abhängigkeit von dem die auf die elastische Dichtung 4 wirkende Presskraft eingestellt wird, könnte ein solcher Parameter auch von der Steuereinrichtung 9 automatisch erfasst werden. Eine solche Erfassung kann über einen geeigneten Sensor erfolgen. So könnte beispielsweise die verwendete elastische Dichtung 4 eine entsprechende Codierung aufweisen, die eine Information ihrer Ausbildung, beispielsweise das Material aus dem sie besteht, enthält. Diese Codierung könnte von einem Sensor erfasst werden und der Steuereinrichtung 9 als Eingangssignal zugeführt werden.

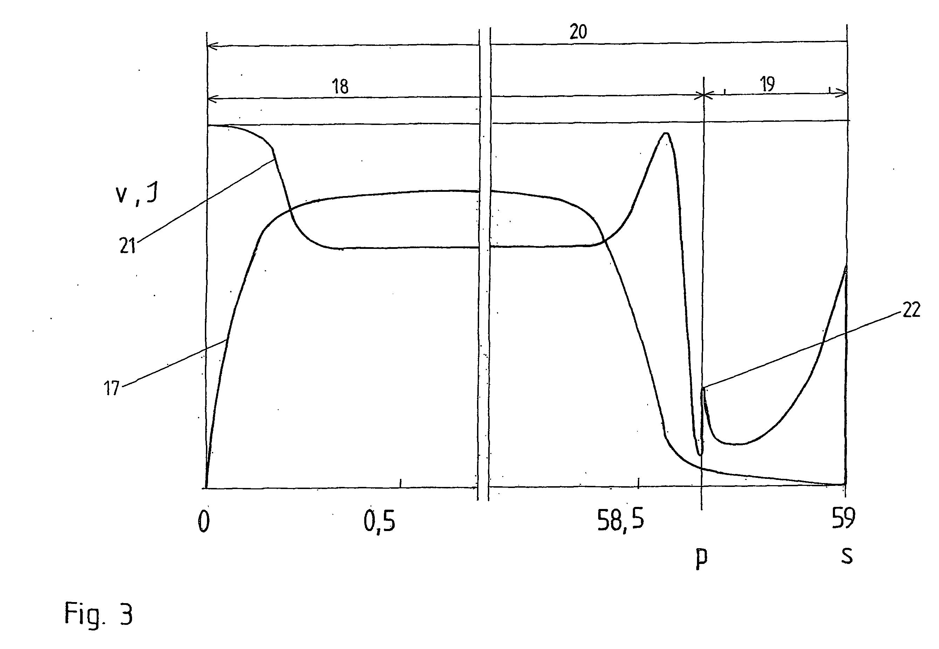

In Fig. 3 ist ein Diagramm dargestellt, in dem als Kurve 17 die Geschwindigkeit v des Verschlussgliedes 3 in Abhängigkeit vom Schließweg s dargestellt ist. Am Anfang des Schließweges s steigt die Geschwindigkeit v zunächst auf einen Wert an, der über den Großteil des Schließweges im Wesentlichen beibehalten wird. Vor Ende des Schließweges sinkt die Geschwindigkeit v wiederum ab, bis am Ende des Schließweges, an dem die elastische Dichtung 4 mit der gewünschten Kraft an die Dichtfläche angedrückt ist, der Stillstand des Verschlussgliedes 3 erreicht ist.

Der Punkt, an welchem die elastische Dichtung 4 auf die Dichtfläche aufsetzt, ist in Fig. 3 eingezeichnet. Der Schließweg bis zu diesem Punkt p kann auch als Schließhub 18 und der Schließweg ab diesem Punkt p bis zur Einstellung als Dichthub 19 bezeichnet werden. Der gesamte Schließweg kann auch als Gesamthub 20 bezeichnet werden.

Im gezeigten Ausführungsbeispiel ist der gesamte Schließweg s beispielhaft mit 59mm angegeben.

Die Geschwindigkeit v des Verschlussglieds 3, mit der dieses den Aufsetzpunkt p anfährt, kann von der Steuereinrichtung 9 eingestellt werden. Die Größe dieser Geschwindigkeit v am Aufsetzpunkt p (= Aufsetzgeschwindigkeit) kann hierbei in Abhängigkeit von mindestens einer Eingangsgröße für die Steuerung oder Regelung eingestellt werden, beispielsweise in Abhängigkeit vom Material, aus dem die elastische Dichtung 4 besteht. Es sind insbesondere elastische Dichtungen aus FKM (Viton), FFKM oder Silikon bekannt. Beispielsweise kann für eine Dichtung aus einem FFKM-Material eine geringere Aufsetzgeschwindigkeit als für eine aus FKM oder Silikon bestehende Dichtung gewählt werden.

In Fig. 3 ist außerdem als Kurve 21 der Betrag des vom Aktuator aufgenommenen Stromes 1 über den Schließweg s dargestellt. Nach der anfänglichen Beschleunigung des Aktuators 5 sinkt der Strom I auf einen über den Großteil des Schließweges im Wesentlichen konstanten Wert (vorzugsweise beträgt die Variation weniger als 10%). Zum Bremsen des Verschlussgliedes 3 kurz vor Erreichen des Aufsetzpunktes p steigt die zugeführte Stromstärke zunächst an, um in der Folge wieder abzufallen. Mit dem Auftreffen der Dichtung 4 auf die Dichtfläche am Aufsetzpunkt p geht ein Peak 22 (= ein Anstieg und Abfall der Stromstärker über einen relativ kurzen Intervall) der Stromstärke einher. Im Anschluss an diesen Peak steigt die Stromstärke I mit zunehmender Verpressung der elastischen Dichtung 4 zum Ende des Schließweges hin an. In der Schließstellung kann die Stromzufuhr nach Aktivierung der Haltevorrichtung 36 abgeschaltet werden.

Günstigerweise wird mindestens 20%, vorzugsweise mindestens 40%, der für den gesamten Schließweg s benötigten Zeit für den letzten Abschnitt des Schließweges s aufgewendet, der sich über den doppelten Dichthub 19 erstreckt.

Aus dem Peak 22 der Stromstärke kann der Aufsetzpunkt p von der Steuereinrichtung 9 ermittelt werden.

Wenn die Erfassung des aktuellen Wertes des Aufsetzpunktes p wiederholt durchgeführt wird, so kann aus der Lage des Aufsetzpunktes p z. B. auf den Verschleiß der Dichtung geschlossen werden. Aufgrund von Abrieb und nicht vollständiger Rückstellung auf die ursprüngliche Form nach wiederholter Kompression verschiebt sich der Aufsetzpunkt p zunehmend weiter weg vom Anfangspunkt des Schließweges oder einem anderen Fixpunkt in Bezug auf den Ventilkörper 1, der beim Schließen des Vakuumventils überfahren wird. Wenn der Vergleich des erfassten aktuellen Wertes des Aufsetzpunktes mit einem vorgegebenen Grenzwert einen zu großen Verschleiß der elastischen Dichtung 4 ergibt, so wird von der Steuereinrichtung 9 ein Servicesignal ausgegeben, das einen erforderlichen Austausch der elastischen Dichtung 4 anzeigt.

In Abhängigkeit von der ermittelten Lage des Aufsetzpunktes p kann beispielsweise auch die auf die elastische Dichtung 4 ausgeübte Presskraft in der Schließstellung des Verschlussgliedes 3 angepasst werden. So kann diese Presskraft bei einem höheren Verschleiß erhöht werden, um nach wie vor eine gewünschte Gasdichtheit (Leckrate) zu erreichen.

Anstelle der zuvor beschriebenen Kraftsteuerung oder -regelung kann die auf die elastische Dichtkraft wirkende Presskraft auch durch eine Wegsteuerung oder -regelung (= Lage- oder Positionssteuerung oder-regelung) durchgeführt werden. Beispielsweise kann hierzu wie beschrieben der Aufsetzpunkt p der elastischen Dichtung 4 auf die Dichtfläche 35 ermittelt werden und das Verschlussglied 3 anschließend an diesen Aufsetzpunkt p um einen gewünschten Weg weiter in Richtung zur Dichtfläche 35 verfahren werden (d. h. ein gewünschter Dichthub wird durchgeführt).

Wenn beim Schließen die vorgegebene Schließstellung erreicht ist, wird die Haltevorrichtung (Bremse) 36 betätigt, um die eingestellte Presskraft zu fixieren. Darauf kann die Zufuhr des Betriebsmittels, im vorliegenden Fall die Stromzufuhr, abgestellt werden.

Im Fall eines Ausfalls des Betriebsmittels kann durch eine selbstschließende Ausbildung der Haltevorrichtung 36 ein Feststellen des Verschlussgliedes 3 an der Stelle durchgeführt werden, an der es sich gerade befindet, was ein Sicherheitsmerkmal darstellt.

Die in der Schließstellung des Verschlussglieds 3 auf die elastische Dichtung 4 wirkende Presskraft kann von der Steuereinrichtung 9 auch in Abhängigkeit vom zwischen den beiden Vakuumkammern 11, 12 wirkenden Differenzdruck eingestellt werden, wie dies bekannt ist.

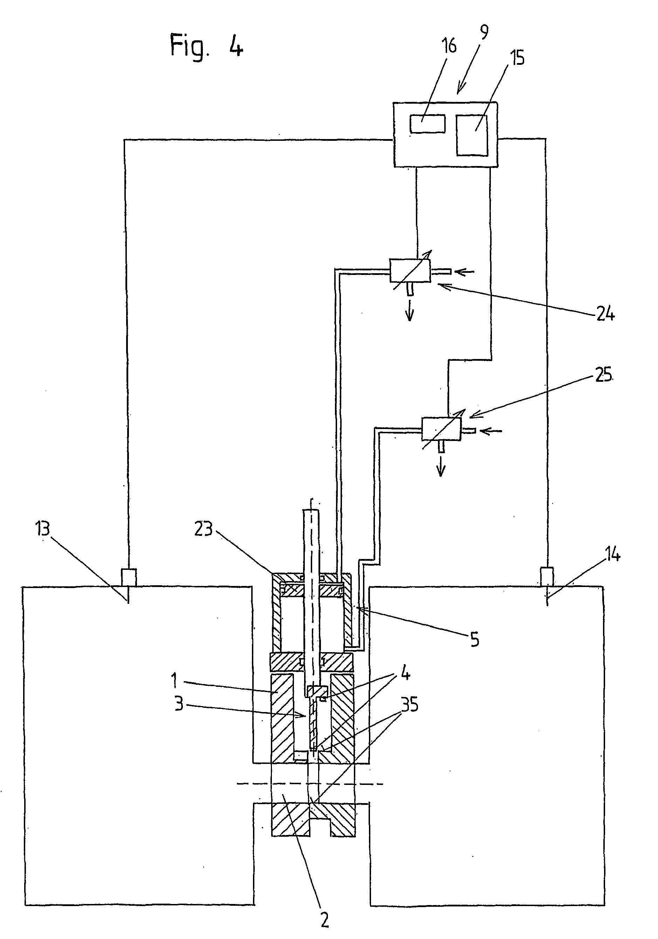

Ein Ausführungsbeispiel für ein pneumatisch betriebenes Vakuumventil ist schematisch in Fig. 4 dargestellt. Hier wird dem Aktuator 5 unter Druck stehende Luft als Betriebsmittel zugeführt. Über die Stellglieder 24, 25 kann die von der Kolben-Zylinder-Einheit ausgeübte Schließkraft eingestellt werden. Weiters kann, um eine effektive Regelung der Geschwindigkeit des Verschlussgliedes 3 durchführen zu können, vorgesehen sein, den Kolben 23 des Aktuators 5 gleichzeitig beidseitig mit Druckluft zu beaufschlagen, wobei die Druckdifferenz in den beiden Zylinderräumen von der Steuereinrichtung 9 über entsprechende Stellglieder 24, 25 einstellbar ist.

Der Aufsetzpunkt p der elastischen Dichtung 4 auf die Dichtfläche 35 könnte hier gegebenenfalls aus dem Druckverlauf über den Schließweg s erfasst werden.

Unabhängig von der Art des verwendeten Aktuators 5, könnte der Aufsetzpunkt p beispielsweise auch optisch mittels einer Kamera erfasst werden.

Die Steuerung bzw. Regelung des Vakuumventils kann bei diesem Ausführungsbeispiel in analoger Weise wie zuvor anhand der Fig. 1 bis 3 beschrieben, erfolgen, wobei die Steuerung oder Regelung des Verschlussgliedes 3 anstatt wie zuvor über die Stromstärke nunmehr über den Druck bzw. die Druckdifferenz des Betriebsmittels erfolgt.

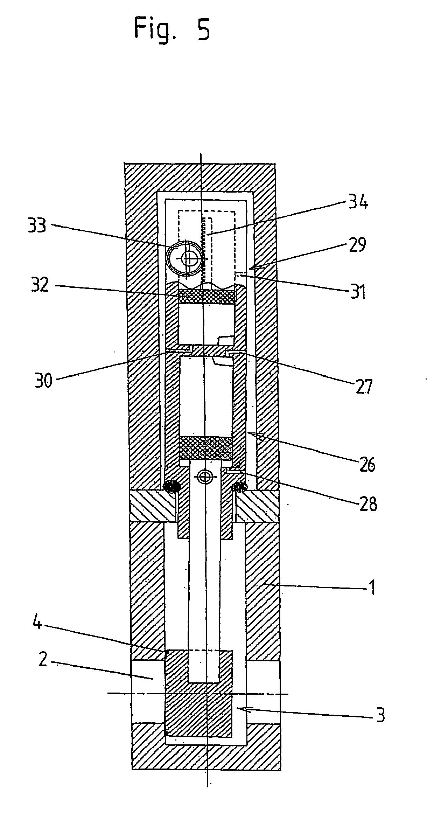

Die verschiedenen beschriebenen Aspekte der Erfindung sind auch bei unterschiedlich anders ausgebildeten Vakuumventilen ausführbar. In Fig. 5 ist lediglich beispielhaft ein L-Ventil dargestellt. Mittels des als Kolben-Zylinder-Einheit ausgebildeten Aktuators 26 wird das Verschlussglied 3 zwischen seiner Offenstellung und einer der Dichtfläche gegenüberliegenden, aber von der Dichtfläche noch abgehobenen Stellung verstellt, zu welchem Zweck die Druckluftleitungen 27, 28 entsprechend mit Druckluft beaufschlagt und entlüftet werden. Mittels des Aktuators 29, der ebenfalls von einer Kolben-Zylinder-Einheit gebildet wird, wird das Verschlussglied 3 an den die Dichtfläche aufweisenden Ventilsitz angedrückt, zu welchem Zweck die Druckluftleitungen 30, 31 entsprechend mit Druckluft beaufschlagt werden bzw. entlüftet werden, um den Kolben 32 zu verfahren. Die Anpressung der Dichtung 4 an die am Ventilkörper 1 angeordnete Dichtfläche erfolgt durch das exzentrisch gelagerte Zahnrad 33, das mit der am Kolben 32 angeordneten Zahnstange 34 zusammenwirkt. Durch Einstellung des Drucks der durch die Druckluftleitung 30 zugeführten Druckluft ist die vom Aktuator 29 ausgeübte Schließkraft von der Steuereinrichtung 9 einstellbar. Hierbei kann der zwischen den beiden Seiten des Verschlussgliedes 3 vorliegende Differenzdruck berücksichtigt werden, um einen gewünschten Wert der auf die elastische Dichtung 4 ausgeübten Presskraft einzustellen. Die Einstellung der Presskraft 4 kann hierbei wiederum in Abhängigkeit mindestens eines Parameters erfolgen, wie dies im Einzelnen im Zusammenhang mit dem in den

Fig. 1 bis 3 dargestellten Ausführungsbeispiel erläutert worden ist.

Anstelle eines Aktuators, dessen Schließkraft einstellbar ist, kann für die unterschiedlichen Arten von Vakuumventilen, bei denen das erfindungsgemäße Verfahren durchführbar ist, auch Aktuatoren eingesetzt werden, mit denen die Schließposition einstellbar ist, wie dies im Zusammenhang mit den Fig. 1 und 2 bereits beispielhaft erläutert worden ist. Wenn hierbei eine Regelung der Schließposition durchgeführt wird (mit einer Rückführung des Ist-Wertes der Schließposition), so ergibt sich die Verpressung der Dichtung direkt aus der eingestellten Schließposition und ist (für alle Arten von Vakuumventilen) im Wesentlichen unabhängig vom Differenzdruck zwischen den beiden Seiten des Verschlussglieds 3.

Beispielsweise kann die volle Verpressung der elastischen Dichtung 4 im Schließzustand des Verschlussglieds 3, also der Schließhub, im Bereich von 5 bis 10% des Durchmessers der Dichtung liegen. Bei einem Durchmesser der elastischen Dichtung von z. B. 5,3 mm liegt ein typischer Wert für die volle Verpressung im Bereich von 0,3 mm. Diese volle Verpressung wird im Servicemodus der Dichtung durchgeführt. Im Prozessmodus beträgt die Verpressung günstiger Weise weniger als 30%, vorzugsweise weniger als 10% der vollen Verpressung.

Diese Werte für den Schließhub gelten günstiger Weise auch bei einer Kraftsteuerung oder -regelung.

In allen Ausführungsbeispielen kann durch eine Überwachung der für das Verstellen des Verschlussgliedes 3 benötigten Kraft ein Einklemmschutz gegenüber Fremdkörpern bereitgestellt werden. Insbesondere kann bei einer Erfassung des Aufsetzpunktes p überwacht werden, ob beim Schließen ein einen vorgegebenen Grenzwert überschreitender Kraftanstieg vor erreichen des Aufsetzpunktes p auftritt, um einen solchen Einklemmschutz zu realisieren.

Zur Erfassung des Ortes und/oder der Geschwindigkeit des Verschlussgliedes 3 können unterschiedliche Arten von Sensoren eingesetzt werden, beispielsweise optische oder induktive Sensoren.

Eine Fixierung des Verschlussgliedes 3 in seiner Schließstellung könnte beispielsweise auch durch eine selbsthemmende Ausbildung von die Bewegung des Aktuators 5 übertragenden Getriebegliedern (beispielsweise selbsthemmenden Spindelhubgetrieben) oder des Aktuators selbst erreicht werden oder indem Getriebeglieder über einen Todpunkt verfahren werden.

### Legende zu den Hinweisziffern:

- 1: Ventilkörper
- 2: Ventilöffnung
- 3: Verschlussglied
- 4: elastische Dichtung
- 5: Aktuator
- 6: Ritzel
- 7: Zahnstange
- 8: Dichtung
- 9: Steuereinrichtung
- 10: Sensor
- 11: Vakuumkammer
- 12: Vakuumkammer
- 13: Drucksensor
- 14: Drucksensor
- 15: Eingabevorrichtung
- 16: Ausgabevorrichtung
- 17: Kurve
- 18: Schließhub
- 19: Dichthub
- 20: Gesamthub
- 21: Kurve
- 22: Peak
- 23: Kolben
- 24: Stellglied
- 25: Stellglied
- 26: Aktuator
- 27: Druckluftleitung
- 28: Druckluftleitung
- 29: Aktuator
- 30: Druckluftleitung
- 31: Druckluftleitung
- 32: Kolben
- 33: Zahnrad
- 34: Zahnstange
- 35: Dichtfläche
- 36: Haltevorrichtung
- 37: Reibelement

## Patentansprüche

1. Verfahren zur Steuerung oder Regelung eines Vakuumventils, welches umfasst:
- einen Ventilkörper (1) mit einer Ventilöffnung (2),
- ein Verschlussglied (3), das, zum Schließen des Vakuumventils zwischen einer Offenstellung und einer Schließstellung verstellbar ist und in der Schließstellung die Ventilöffnung (2) verschließt, wobei mindestens eine elastische Dichtung (4) mit einer Presskraft an eine Dichtfläche (35) angedrückt ist,
- einen Aktuator (5) zum Verstellen des Verschlussglieds (3) und
- eine Steuereinrichtung (9), mittels der der Aktuator (5) angesteuert wird und von der die in der Schließstellung des Verschlussglieds (3) auf die elastische Dichtung (4) wirkende Presskraft eingestellt wird,
**dadurch gekennzeichnet, dass** die Einstellung der auf die elastische Dichtung (4) wirkenden Presskraft in Abhängigkeit von mindestens einem von einem Benutzer eingebbaren Parameter erfolgt.

2. Verfahren zur Steuerung oder Regelung eines Vakuumventils, welches umfasst:
- einen Ventilkörper (1) mit einer Ventilöffnung (2),
- ein Verschlussglied (3), das zum Schließen des Vakuumventils zwischen einer Offenstellung und einer Schließstellung verstellbar ist und in der Schließstellung die Ventilöffnung (2) verschließt, wobei mindestens eine elastische Dichtung (4) mit einer Presskraft an eine Dichtfläche (35) angedrückt ist,
- einen Aktuator (5) zum Verstellen des Verschlussglieds (3) und
- eine Steuereinrichtung (9), mittels der der Aktuator (5) angesteuert wird und von der die in der Schließstellung des Verschlussglieds (3) auf die elastische Dichtung (4) wirkende Presskraft eingestellt wird,
**dadurch gekennzeichnet, dass** die Einstellung der auf die elastische Dichtung (4) wirkenden Presskraft in Abhängigkeit von mindestens einem Parameter erfolgt, der eine von mindestens zwei möglichen Konfigurationen des Vakuumventils oder einen von mindestens zwei möglichen Betriebsmodi des Vakuumventils darstellt.

3. Verfahren nach Anspruch 2, **dadurch gekennzeichnet, dass** als Betriebsmodi zumindest ein Prozessmodus und ein Servicemodus vorhanden sind, wobei im Servicemodus von der Steuereinrichtung (9) eine höhere auf die elastische Dichtung (4) wirkende Presskraft als im Prozessmodus eingestellt wird.

4. Verfahren nach Anspruch 2 oder 3, **dadurch gekennzeichnet, dass** vom Benutzer eine Eingabe zur Auswahl zwischen den mindestens zwei Betriebsmodi durchführbar ist, in Abhängigkeit von der die Einstellung der auf die elastische Dichtung (4) wirkende Presskraft erfolgt.

5. Verfahren nach einem der Ansprüche 2 bis 4, **dadurch gekennzeichnet, dass** die auf die elastische Dichtung (4) wirkende Presskraft in Abhängigkeit von der Ausbildung der elastischen Dichtung (4) oder des Verschlussgliedes (3) eingestellt wird, wobei mindestens zwei unterschiedliche Ausbildungen von elastischen Dichtungen (4) und/oder Verschlussgliedern (3) verwendbar sind.

6. Verfahren nach Anspruch 5, **dadurch gekennzeichnet, dass** vom Benutzer eine Eingabe zur Auswahl zwischen den mindestens zwei unterschiedlichen Ausbildungen der elastischen Dichtung (4) und/oder des Verschlussgliedes (5) durchführbar ist, in Abhängigkeit von der die Einstellung der auf die elastische Dichtung (4) wirkenden Presskraft erfolgt.

7. Verfahren nach einem der Ansprüche 1 bis 6, **dadurch gekennzeichnet, dass** die Einstellung der auf die elastische Dichtung (4) wirkenden Presskraft in Abhängigkeit von der Art mindestens eines mit der elastischen Dichtung in Berührung kommenden Prozessgases erfolgt.

8. Verfahren nach Anspruch 7, **dadurch gekennzeichnet, dass** die Art des Prozessgases vom Benutzer eingebbar ist.

## Claims

1. A method of controlling or regulating a vacuum valve comprising:
- a valve body (1) with a valve opening (2),
- a closure member (3) which is displaceable between an open position and a closed position in order to close the vacuum valve and which closes the valve opening (2) in the closed position, wherein at least one resilient seal (4) is pressed against a sealing surface (35) with a pressing force,
- an actuator (5) for displacing the closure member (3) and
- a control device (9) by means of which the actuator (5) is controlled and by which the pressing force acting upon the resilient seal (4) in the closed position of the closure member (3) is adjusted,
**characterised in that** the adjustment of the pressing force acting upon the resilient seal (4) takes place as a function of at least one parameter able to be entered by a user.

2. A method of controlling or regulating a vacuum valve comprising:
- a valve body (1) with a valve opening (2),
- a closure member (3) which is displaceable between an open position and a closed position in order to close the vacuum valve and which closes the valve opening (2) in the closed position, wherein at least one resilient seal (4) is pressed against a sealing surface (35) with a pressing force,
- an actuator (5) for displacing the closure member (3) and
- a control device (9) by means of which the actuator (5) is controlled and by which the pressing force acting upon the resilient seal (4) in the closed position of the closure member (3) is adjusted,
**characterised in that** the adjustment of the pressing force acting upon the resilient seal (4) takes place as a function of at least one parameter which constitutes one of at least two possible configurations of the vacuum valve or one of at least two possible operating modes of the vacuum valve.

3. A method according to claim 2, **characterised in that** at least a process mode and a service mode are present as operating modes, wherein the control device (9) adjusts the pressing force acting upon the resilient seal (4) to be greater in the service mode than in the process mode.

4. A method according to claim 2 or 3, **characterised in that** an entry for selection between the at least two operating modes can be made by the user, as a function of which entry there takes place the adjustment of the pressing force acting upon the resilient seal (4).

5. A method according to any one of claims 2 to 4, **characterised in that** the pressing force acting upon the resilient seal (4) is adjusted as a function of the construction of the resilient seal (4) or the closure member (3), wherein at least two different constructions of resilient seals (4) and/or closure members (3) can be used.

6. A method according to claim 5, **characterised in that** an entry for selection between the at least two different constructions of the resilient seal (4) and/or the closure member (5) can be carried out by the user, as a function of which entry there takes place the adjustment of the pressing force acting upon the resilient seal (4).

7. A method according to any one of claims 1 to 6, **characterised in that** the adjustment of the pressing force acting upon the resilient seal (4) takes place as a function of the type of at least one process gas coming into contact with the resilient seal.

8. A method according to claim 7, **characterised in that** the type of process gas can be entered by the user.

## Revendications

1. Procédé de commande ou de réglage d'une vanne à vide, laquelle comprend :
- un corps de vanne (1) comportant un orifice (2) ;
- un organe de fermeture (3) réglable pour fermer la vanne à vide entre une position ouverte et une position fermée et qui, dans une position fermée, obture l'orifice (2), au moins un joint élastique (4) étant pressé contre une surface d'étanchéité (35) à l'aide d'une force de pression,
- un actuateur (5) pour déplacer l'organe de fermeture (3) et
- un dispositif de commande (9) au moyen duquel l'actuateur (5) est commandé et qui ajuste la force de pression agissant sur le joint élastique (4) lorsque organe de fermeture (3) est en position fermée,
**caractérisé en ce que**
l'ajustement de la force de pression agissant sur le joint élastique (4) intervient en fonction d'au moins un paramètre pouvant être saisi par un utilisateur.

2. Procédé de commande ou de réglage d'une vanne à vide, laquelle comprend :
- un corps de vanne (1) comportant un orifice (2) ;
- un organe de fermeture (3) réglable pour fermer la vanne à vide entre une position ouverte et une position fermée et qui, dans une position fermée, obture l'orifice (2), au moins un joint élastique (4) étant pressé contre une surface d'étanchéité (35) à l'aide d'une force de pression,
- un actuateur (5) pour déplacer l'organe de fermeture (3) et
- un dispositif de commande (9) au moyen duquel l'actuateur (5) est commandé et qui ajuste la force de pression agissant sur le joint élastique (4) lorsque l'organe de fermeture (3) est en position fermée,
**caractérisé en ce que**
l'ajustement de la force de pression agissant sur le joint élastique (4) intervient en fonction d'au moins un paramètre qui représente au moins deux configurations possibles de la vanne à vide ou un d'au moins deux modes de fonctionnement possibles de la vanne à vide.

3. Procédé selon la revendication 2,
**caractérisé en ce que**
les modes de fonctionnement existants sont au moins un mode process et un mode service, le dispositif de commande (9) ajustant, en mode service, une force de pression agissant sur le joint élastique (4) supérieure à celle du mode process.

4. Procédé selon la revendication 2 ou la revendication 3,
**caractérisé en ce que**
l'utilisateur peut saisir une donnée pour sélectionner au moins un des deux modes de fonctionnement en fonction de l'ajustement de la force de pression agissant sur le joint élastique (4).

5. Procédé selon l'une quelconque des revendications 2 à 4,
**caractérisé en ce que**
la force de pression agissant sur le joint élastique (4) est ajustée en fonction de la conformation du joint élastique (4) ou de l'organe de fermeture (3), au moins deux conformations différentes de joints élastiques (4) et/ou d'organes de fermeture (3) pouvant être utilisées.

6. Procédé selon la revendication 5,
**caractérisé en ce que**
l'utilisateur peut choisir entre au moins deux conformations différentes du joint élastique (4) et/ou de l'organe de fermeture (5), en fonction de l'ajustement de la force de pression agissant sur le joint élastique (4).

7. Procédé selon l'une quelconque des revendications 1 à 6,
**caractérisé en ce que**
l'ajustement de la force de pression agissant sur le joint élastique (4) intervient en fonction du type d'au moins un gaz process entrant en contact avec le joint élastique.

8. Procédé selon la revendication 7,
**caractérisé en ce que**
le type de gaz process peut être saisi par l'utilisateur.
